# EUROPEAN PATENT APPLICATION

(11) **EP 1 944 083 A1**
(43) Date of publication of application: **16.07.2008**
(21) Application number: 06797556.5
(22) Date of filing: 06.09.2006
(51) Int. Cl.: B01J 27/24, B01J 35/02, C01B 21/06, C30B 29/38, H01L 21/205

(54) **GROUP III/V NITRIDE SEMICONDUCTOR, PHOTOCATALYST SEMICONDUCTOR ELEMENT, PHOTOCATALYTIC REDOX REACTION APPARATUS, AND PHOTOELECTROCHEMICAL REACTION EXECUTION METHOD**

(30) Priority: 06.09.2005 JP 2005257908
(71) Applicant: Japan Science and Technology Agency, Kawaguchi-shi, Saitama 332-0012 (JP); Tokyo University of Science Educational Foundation Administrative Organization, Tokyo, 162-8601 (JP)
(72) Inventor: FUJII, Katsushi, Ibaraki 315-0052 (JP); OHKAWA, Kazuhiro, Saitama 336-0917 (JP); ONO, Masato, Kanagawa 236-0045 (JP); ITO, Takashi, Chiba 270-1108 (JP)
(74) Representative: Grünecker, Kinkeldey, Stockmair & Schwanhäusser Anwaltssozietät
(86) International application number: PCT/JP2006/317661
(87) International publication number: WO 2007/029744

(57) **Abstract**

Provided are a III/V group nitride semiconductor causing an oxidation-reduction reaction at a high photoconversion efficiency by irradiation of light, a photocatalytic semiconductor device, a photocatalytic oxidation-reduction reaction apparatus, and an execution process of a photoelectrochemical reaction.

In the III/V group nitride semiconductor, the full width at half maximum of an X-ray rocking curve on a catalytic reaction surface thereof is 400 arcsec or less, and a carrier density in a surface layer portion having the catalytic reaction surface is 1.5 x 10¹⁶ cm⁻³ or more, but 3.0 x 10¹⁸ cm⁻³ or less. The photocatalytic semiconductor device has the III/V group nitride semiconductor laminated on a substrate. In the photocatalytic oxidation-reduction reaction apparatus, one electrode of a pair of electrodes for electrolysis, which are electrically connected to each other in a state brought into contact with an electrolyte, is composed of the III/V group nitride semiconductor, and a catalytic reaction surface making up the III/V group nitride semiconductor is irradiated with light, thereby causing an oxidation reaction or reduction reaction on the catalytic reaction surface.

## Description

### TECHNICAL FIELD

The present invention relates to a III/V group nitride semiconductor developing a catalytic action of an oxidation-reduction reaction by receiving light, a photocatalytic semiconductor device, a photocatalytic oxidation-reduction reaction apparatus and an execution process of a photoelectrochemical reaction.

### BACKGROUND ART

In recent years, it has been widely conducted to utilize a photocatalyst, thereby, for example, electrolyzing water by irradiation of light in a field of energy to obtain energy such as hydrogen gas or decomposing noxious substances or organic substances by irradiation of light in a field of environment.
As the photo-catalyst, a III/V group nitride semiconductor compound, for example, gallium nitride (GaN), may be preferably used in a photocatalytic reaction in, for example, a high-temperature operation environment because the compound is high in durability against heat or the like, gas resistance and solvent resistance.

As examples of the III/V group nitride semiconductor compound, those used as semiconductor light-emitting devices are disclosed (see, for example, Patent Art. 1 and Patent Art. 2). In different semiconductor compounds having an equivalent carrier density, a compound having higher single crystallinity, i.e., reduced in crystal defect density is generally higher in carrier mobility, so that in the III/V group nitride semiconductor compounds in Patent Art. 1 and Patent Art. 2, the degree of single crystallinity and the degree of crystal defect density are defined by the full width at half maximum of an X-ray rocking curve for the purpose of obtaining a high luminous efficiency due to high carrier mobility.

However, these compounds are used as semiconductor light-emitting devices, and no compound improved in energy conversion efficiency such as photocatalytic efficiency by paying attention to crystal characteristics in the case where the compound is used as a photocatalyst in an oxidation-reduction reaction has been present up to date. Patent Art. 1: Japanese Patent Application Laid-Open No. 2001-135575
Patent Art. 2: Japanese Patent Application Laid-Open No. 2003-63898

### DISCLOSURE OF THE INVENTION

The present invention has been made in view of the foregoing circumstances and has as its object the provision of a III/V group nitride semiconductor for photocatalytic oxidation-reduction reaction, by which an oxidation-reduction reaction can be caused at a high photoconversion efficiency by irradiation of light, and a photocatalytic semiconductor device having such a semiconductor.
Another object of the present invention is to provide a photocatalytic oxidation-reduction reaction apparatus, by which an oxidation-reduction reaction can be caused at a high photoconversion efficiency by irradiation of light, and an execution process of a photoelectrochemical reaction making use of the apparatus.

The III/V group nitride semiconductor according to the present invention is a III/V group nitride semiconductor for photocatalytic oxidation-reduction reaction, wherein
the full width at half maximum of an X-ray rocking curve on a catalytic reaction surface of the III/V group nitride semiconductor is 400 arcsec or less, and
a carrier density in a surface layer portion having the catalytic reaction surface is 1.5 x 10¹⁶ cm⁻³ or more, but 3.0 x 10¹⁸ cm⁻³ or less.

In the III/V group nitride semiconductor according to the present invention, the resistivity of the surface layer portion may preferably be 7 x 10⁻³ Ωcm or more, but 6 x 10⁻¹ Ωcm or less.

The photocatalytic semiconductor device according to the present invention is a photocatalytic semiconductor device for photocatalytic oxidation-reduction reaction, wherein
the III/V group nitride semiconductor is laminated on a substrate.

The photocatalytic oxidation-reduction reaction apparatus according to the present invention is a photocatalytic oxidation-reduction reaction apparatus for photocatalytic oxidation-reduction reaction, wherein
one electrode of a pair of electrodes for electrolysis, which are electrically connected to each other in a state brought into contact with an electrolyte, is composed of the III/V group nitride semiconductor, and
a catalytic reaction surface making up the III/V group nitride semiconductor is irradiated with light, thereby causing an oxidation reaction or reduction reaction on the catalytic reaction surface.

The photocatalytic oxidation-reaction reaction apparatus according to the present invention may be so constructed that the catalytic reaction surface in the III/V group nitride semiconductor is irradiated with light, and a voltage is applied between the pair of electrodes for electrolysis, thereby causing the oxidation reaction or reduction reaction on the catalytic reaction surface.

The execution process of a photoelectrochemical reaction according to the present invention comprises using the III/V group nitride semiconductor and irradiating the catalytic reaction surface in the III/V group nitride semiconductor with exciting light to cause an oxidation reaction or reduction reaction on the catalytic reaction surface.

According to the III/V group nitride semiconductor and photocatalytic semiconductor device of the present invention, the surface layer portion to be irradiated with light has the full width at half maximum of the X-ray rocking curve of the specific size and the specific carrier density, so that a high carrier mobility is achieved in the surface layer portion, whereby a carrier generated by irradiation of light comes to contribute to an oxidation-reduction reaction in the catalytic reaction surface at a high efficiency, and the oxidation-reduction reaction can be caused at a high photoconversion efficiency by the irradiation of light after all.

According to the photocatalytic oxidation-reduction reaction apparatus and execution process of the photoelectrochemical reaction of the present invention, the surface layer portion to be irradiated with light has the full width at half maximum of the X-ray rocking curve of the specific size and the specific carrier density, so that the oxidation-reduction reaction can be caused at a high photoconversion efficiency by the irradiation of light on the catalytic reaction surface.

### BRIEF DESCRIPTION OF THE DRAWINGS

[FIG. 1] is a typical cross-sectional view illustrating the exemplary construction of a photocatalytic semiconductor device having a III/V group nitride semiconductor according to the present invention in a state that a collecting member has been provided.
[FIG. 2] is a typical cross-sectional view illustrating the exemplary construction of a photocatalytic oxidation-reduction reaction apparatus equipped with the photocatalytic semiconductor device having the III/V group nitride semiconductor according to the present invention.
[FIG. 3] is a graph illustrating a relationship between a light-induced current density and an applied voltage in a state that irradiation of light to a III/V group nitride semiconductor has been conducted as to Examples 1 to 3 and Comparative Examples 1 to 3.
[FIG. 4] is a graph illustrating a relationship between the full width at half maximum of an X-ray rocking curve and an energy efficiency as to Examples 1 to 3 and Comparative Examples 1 to 3.
[FIG. 5] is a graph illustrating a relationship between a carrier density and a light-induced current density in a state that irradiation of light to a III/V group nitride semiconductor has been conducted as to Examples 4A to 4G.
[fog. 6] is a graph illustrating a relationship between the full width at half maximum of an X-ray rocking curve and an energy efficiency as to Examples 5A to 5G and Comparative Examples 5h and 5i.

### DESCRIPTION OF CHARACTERS

- 10: Photocatalytic semiconductor device
- 11: Photocatalytic oxidation-reduction apparatus
- 12: Electrolytic bath
- 12A: Oxidation bath
- 12B: Reduction bath
- 12C: Connecting tube
- 12D: Light transmitting window
- 12E,: 12F Gas collecting tubes
- 15: Opening
- 16: O-ring
- 17: Reference electrode
- 18: Metal electrode
- 19: Potentiostat
- 19a: Power source for application of voltage
- L: Light
- 20: III/V group nitride semiconductor
- 20A: Photocatalytic function layer portion
- 21: Buffer layer
- 25: Substrate
- 27: Collecting member
- 27a: Gold layer
- 27b: Titanium layer
- 28: Solder
- 29: Conductive wire
- R: Catalytic reaction surface

### BEST MODE FOR CARRYING OUT THE INVENTION

The present invention will hereinafter be described specifically.

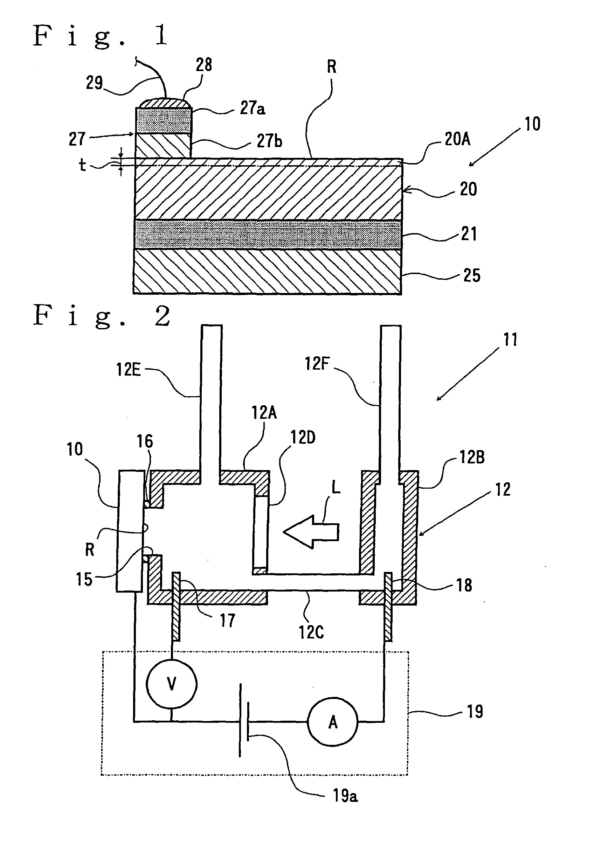

FIG. 1 is a typical cross-sectional view illustrating the exemplary construction of a photocatalytic semiconductor device having a III/V group nitride semiconductor according to the present invention in a state that a collecting member has been provided.

### <III/V group nitride semiconductor>

The III/V group nitride semiconductor 20 according to the present invention is used for a photocatalytic oxidation-reduction reaction and composed of, for example, a III/V group nitride semiconductor compound (hereinafter also referred to as "III/V group compound") represented by the following general formula (1). General formula (1) : Al_{y}Ga_{1-x-y}InₓN [In the general formula (1), 0 ≤ x ≤ 1, and 0 ≤ y ≤ 1.]
When the III/V group nitride semiconductor compound represented by the general formula (1) is used in, for example, oxidation-reduction of water, x and y are preferably defined by x - y ≤ 0.45, 0 ≤ x ≤ 1, and 0 ≤ y ≤ 1.

Such a III/V group nitride semiconductor 20 is formed in a state of a single layer or multi-layer, and the full width at half maximum of an X-ray rocking curve (ω scan) in a catalytic reaction surface R to be irradiated with light in the III/V group nitride semiconductor 20 is 400 arcsec or less, preferably 300 arcsec or less, more preferably 100 arcsec or less. A carrier density in a surface layer portion (hereinafter also referred to as "photocatalytic function layer portion") 20A having the catalytic reaction surface R is 1.5 x 10¹⁶ cm⁻³ or more, but 3.0 x 10¹⁸ cm⁻³ or less, preferably 3.0 x 10¹⁶ cm⁻³ or more, but 1.5 x 10¹⁸ cm⁻³ or less, more preferably 5.0 x 10¹⁶ cm⁻³ or more, but 8.0 x 10¹⁷ cm⁻³ or less.

The photocatalytic function layer portion 20A is a portion that when the catalytic reaction surface R or a surface opposing to the surface is irradiated with exciting light L (see FIG. 2), a carrier is generated by the exciting light L, and an oxidation reaction or reduction reaction is caused in the catalytic reaction surface R by the carrier generated. This photocatalytic function layer portion 20A is a portion where a depth from the catalytic reaction surface R is 0.01 to 0.5 µm, preferably 0.01 to 0.2 µm, more preferably 0.01 to 0.1 µm.

As methods for measuring the full width at half maximum of the X-ray rocking curve, may be mentioned suitable publicly known methods. For example, the full width at half maximum can be obtained by measuring the full width at half maximum of an X-ray rocking curve in a (0002) plane where an angle of incidence and an angle of reflection to a direction perpendicular to a (0001) plane that is the catalytic reaction surface R become the same. It is only necessary for this full width at half maximum of the X-ray rocking curve to be the full width at half maximum of an X-ray rocking curve, which is measured at a plane where an angle of incidence and an angle of reflection to a direction perpendicular to the catalytic reaction surface R become the same.

Since the full width at half maximum of the X-ray rocking curve at the catalytic reaction surface R of the III/V group nitride semiconductor 20 is 400 arcsec or less, the crystal defect density in the photocatalytic function layer portion 20A is reduced, and recombination of a carrier generated by irradiation of light through the defect is inhibited, so that the carrier generated can be transported to the catalytic reaction surface R at a high efficiency. The lower limit value of the preferable range of the full width at half maximum of the X-ray rocking curve at the catalytic reaction surface R of the III/V group nitride semiconductor 20 is several tens arcsec that is a practically producible limit. When the full width at half maximum of the X-ray rocking curve exceeds 400 arcsec, a slope of an increment of a light-induced current density to an increment of an applied voltage in the vicinity of zero bias in a graph measuring the relationship between the applied voltage and the light-induced current density, i.e., an energy efficiency becomes small. When such a III/V group nitride semiconductor is used, a high applied voltage is required to achieve a sufficient light-induced current density.

The carrier density in the photocatalytic function layer portion 20A of the III/V group nitride semiconductor 20 is a value measured according to the van der Pauw's method in a state that a magnetic field of 4,000 gauss has been applied at 25°C by presetting a current to a value that the relationship between a current and a voltage when no magnetic field is applied become linear.

If the carrier density in the photocatalytic function layer portion 20A is too low, the III/V group nitride semiconductor itself becomes high in resistance, and the carrier generated by the irradiation of light is converted to heat or the like and eliminated before the carrier is transported to a collecting member, which will be described subsequently. If the carrier density in the photocatalytic function layer portion 20A is too high on the other hand, impurities for achieving the carrier density come to be contained in plenty. As a result, regularity of the crystal itself of the III/V group compound making up the III/V group nitride semiconductor 20 is greatly disordered, so that the III/V group compound itself becomes low in crystal quality. Accordingly, in any carrier density departing from the above range, the light-induced current density obtained in the zero bias does not satisfy a necessary level, and so it is practically difficult to achieve the necessary level.

This III/V group nitride semiconductor 20 preferably has a resistivity of 7 x 10⁻³ Ωcm or more, but 6 x 10⁻¹ Ωcm or less, more preferably 1 x 10⁻² Ωcm or more, but 3 x 10⁻¹ Ωcm or less, particularly preferably 2 x 10⁻² Ωcm or more, but 1 x 10⁻¹ Ωcm or less at the photocatalytic function layer portion 20A thereof. In general, the resistivity is preferably lower until the carrier generated by the irradiation of light is transported to the collecting member. However, when the III/V group nitride semiconductor is formed as one having a low resistivity, such a semiconductor comes to contain impurities related to carrier transmission in plenty to have many crystal defects. As a result, there is a possibility that recombination of a carrier generated by irradiation of light through the defect may occur in plenty. On the other hand, even when the content of impurities is proper, and the carrier density falls within a preferable range, the resulting semiconductor comes to have a high resistivity when the semiconductor involves such problems that the crystal quality itself thereof contains many crystal defects. In such a case, there is also a possibility that recombination of a carrier generated by irradiation of light through the defect may occur in plenty, and so performance as the III/V group nitride semiconductor may not be sufficiently achieved.

Examples of a feed stock for a III group atom in the III/V group compound making up the III/V group nitride semiconductor 20 include trialkylgalliums such as trimethylgallium ((CH₃)₃Ga) (hereinafter also referred to as "TMGa") and triethylgallium ((C₂H₅)₃Ga); trialkylaluminums such as trimethylaluminum ((CH₃)₃Al) and triethylaluminum ((C₂Hₛ)₃Al); and trialkylindiums such as trimethylindium ((CH₃)₃In) and triethylindium ((C₂H₅)₃In). These feed stocks may be used either singly or in any combination thereof.

As a feed stock for a V group atom in the III/V group nitride semiconductor 20, may be used ammonia, hydrazine, methylhydrazine, 1,1-dimethylhydrazine, 1,2-dimethylhydrazine, t-butylamine or ethylenediamine. These feed stocks may be used either singly or in any combination thereof. Among these feed stocks, ammonia is preferably used from the viewpoint of easy handling.

As needed, the III/V group compound making up the III/V group nitride semiconductor 20 may be provided as one doped with, for example, an impurity such as a silicon atom (Si), which is an impurity higher in valence than the III group atom. The III/V group compound is doped with the impurity higher in valence than the III group atom, whereby the resulting III/V group nitride semiconductor 20 is provided as an n-type.
As a feed stock for such a silicon atom (Si), may be used silane (SiH₄), disilane (Si₂H₆) or monomethylsilane (Si(CH₃)H₃).
On the other hand, the III/V group compound is doped with an impurity lower in valence than the III group atom, whereby a p-type III/V group nitride semiconductor can be provided.

Such a III/V group compound making up the III/V group nitride semiconductor 20 preferably has high single crystallinity. The III/V group compound has high single crystallinity, whereby the resulting the III/V group nitride semiconductor 20 is reduced in crystal defect density, and recombination of a carrier generated by irradiation of light is inhibited, so that an oxidation-reduction reaction can be caused at a high photoconversion efficiency.
The term "high single crystallinity" as used herein means that the degree of presence of a grain boundary partitioning one single crystal grain from another single crystal grain is low.

In the III/V group nitride semiconductor 20 described above, various changes may be added.
For example, the III/V group nitride semiconductor is not limited to n-type and p-type, and may be a pn junction semiconductor and the like. In addition, semiconductors of multi-layer structures such as a laminate structure having a level difference in carrier density, a laminate structure formed of a plurality of layers different in single crystallinity and a laminate structure formed of a plurality of III/V group compound layers different in composition may also be used. Further, semiconductors of a laminate structure that only the photocatalytic function layer portion 20A is composed of the III/V group compound, and any other portion is formed of, for example, silicon (Si), germanium (Ge), another III/V group compound, a II-VI group compound semiconductor, or an oxide such as TiO₂ may also be used.

### <Photocatalytic semiconductor device>

The photocatalytic semiconductor device 10 according to the present invention is used for a photocatalytic oxidation-reduction reaction and is obtained by laminating the above-described III/V group nitride semiconductor 20 on a substrate 25 composed of, for example, sapphire, GaN, Si, SiC, LiAlO₃ or LiGaO₃ through, for example, a buffer layer 21.

The thickness of the III/V group nitride semiconductor 20 in the photocatalytic semiconductor device 10 is controlled to, for example, 1.5 to 4.0 µm. This thickness is a thickness necessary for achieving the generation of a carrier by irradiation of light and may be made greater without practical problems from the viewpoint of conductivity.

The III/V group nitride semiconductor 20 in such a photocatalytic semiconductor device 10 can be obtained by using a publicly known crystal growth method such as an atmospheric pressure crystal growth method or reduced pressure crystal growth method according to a metal organic vapor phase epitaxial growth method (MOVPE method).
Specifically, the semiconductor is formed by feeding a feed stock for a V group atom, a feed stock for a III group atom and optionally a feed stock for an impurity to be doped in a gaseous state together with a carrier gas such as hydrogen gas or nitrogen gas on the substrate 25 under heating, thereby causing a thermochemical reaction on the substrate 25 to decompose these feed stocks into constituent elements, and causing these constituent elements to react with one another to grow the intended III/V group compound on the substrate 25.

A heating temperature (hereinafter also referred to as "growth temperature") upon growth of a III/V group compound forming the buffer layer 21 is preferably 400 to 700°C, more preferably 450 to 600°C. If this growth temperature is too low, it may be difficult in some cases to grow the III/V group compound forming the buffer layer. If this growth temperature is too high on the other hand, there is a possibility that the resulting buffer layer may not develop an action of enhancing the single crystallinity of a III/V group nitride semiconductor upon the growth of the III/V group nitride semiconductor on the surface thereof.
The growth temperature of the III/V group compound making up the III/V group nitride semiconductor 20 is higher than the growth temperature of the buffer layer 21 and controlled to, for example, 900 to 1,400 °C, generally 950 to 1,150°C.
The growth temperatures of the buffer layer 21 and III/V group nitride semiconductor 20 are temperatures of the substrate in the respective steps.

According to the III/V group nitride semiconductor 20 and photocatalytic semiconductor device 10 described above, the photocatalytic function layer portion 20A to be irradiated with light has the full width at half maximum of the X-ray rocking curve of the specific size and the specific carrier density, so that a carrier generated by irradiation of light comes to contribute to an oxidation-reduction reaction on the catalytic reaction surface at a high efficiency in the photocatalytic function layer portion 20A, and the oxidation-reduction reaction can be caused at a high photoconversion efficiency by the irradiation of light after all.

In FIG. 1, reference numeral 27 indicates a collecting member formed by laminating a titanium layer 27b and a gold layer 27a in this order on the catalytic reaction surface R of the photocatalytic semiconductor device 10, and reference numeral 29 designates a conductive wire adhered to the collecting member with a solder 28 or the like. No particular limitation is imposed on materials for these collecting member 27 and the like so far as the objects can be achieved.

### <Photocatalytic oxidation-reduction reaction apparatus>

FIG. 2 is a typical cross-sectional view illustrating the exemplary construction of a photocatalytic oxidation-reduction reaction apparatus according to the present invention.
In this photocatalytic oxidation-reduction reaction apparatus 11, one electrode of a pair of electrodes for electrolysis, which are electrically connected to each other in a state brought into contact with an electrolyte, is composed of the photocatalytic semiconductor device 10 having the above-described III/V group nitride semiconductor 20. This photocatalytic semiconductor device 10 is brought into contact with the electrolyte only at the catalytic reaction surface R of the III/V group nitride semiconductor 20.
In the following description, this III/V group nitride semiconductor 20 will be described as an n-type semiconductor.

In this photocatalytic oxidation-reduction reaction apparatus 11, the other electrode corresponding to the photocatalytic semiconductor device 10 is formed by a metal electrode 18 composed of, for example, a metal such as platinum, whereby the photocatalytic semiconductor device 10, which is one electrode, is used as an anode where an oxidation reaction is conducted on the catalytic reaction surface R of the III/V group nitride semiconductor 20 making up this device, and the metal electrode 18, which is the other electrode, used as a cathode where a reaction corresponding to the electrochemical reaction on the catalytic reaction surface R of one electrode, i.e., a reduction reaction is conducted on the surface thereof.

In this photocatalytic oxidation-reduction reaction apparatus 11, the catalytic reaction surface R of the III/V group nitride semiconductor 20 is irradiated with light, thereby casing an oxidation reaction in the photocatalytic semiconductor device 10 and a reduction reaction in the metal electrode 18.
In this invention, the catalytic reaction surface R of the III/V group nitride semiconductor 20 is irradiated with light as described above, and moreover a voltage of a proper intensity is applied between the photocatalytic semiconductor device 10 and the metal electrode 18, whereby the oxidation reaction in the photocatalytic semiconductor device 10 and the reduction reaction in the metal electrode 18 are accelerated. The intensity of the voltage applied at this time is preferably lower than a voltage substantially necessary for the photocatalytic oxidation-reduction reaction caused to react by the irradiation of light because the meaning of developing the photocatalytic action is lost if the voltage higher than this substantially necessary voltage is applied. For example, when an oxidation-reduction reaction of water is conducted, the applied voltage is controlled to substantially 2 V or lower, preferably 1.23 V, which is an electrode potential difference of the electrolysis of water, or lower in view of overvoltage.

Specifically, in the photocatalytic oxidation-reduction reaction apparatus 11, an oxidation bath 12A and a reduction bath 12B are linked to each other at their bottoms through a connecting tube 12C, and gas collecting tubes 12E and 12F, which extend upward in a state linked to these baths, are provided at the respective tops of the oxidation bath 12A and the reduction bath 12B, thereby forming an electrolytic bath 12 filled with an electrolyte. The electrolyte may be provided as, for example, water (H₂O) or an aqueous solution of hydrochloric acid/potassium hydroxide/potassium chloride (HCl/KOH/KCl).
In the oxidation bath 12A, the photocatalytic semiconductor device 10 is provided through an O-ring 16 in a state that an opening 15 formed in a peripheral wall of the oxidation bath 12A has been water-tightly closed in such a manner that the catalytic reaction surface R of the photocatalytic semiconductor device 10 comes into contact with the electrolyte, and in the reduction bath 12B, the metal electrode 18 is inserted in a state extending upward through the bottom thereof. The photocatalytic semiconductor device 10 and the metal electrode 18 are electrically connected to each other through a potentiostat 19. Further, as needed, a reference electrode 17 composed of, for example, a silver/silver chloride/sodium chloride electrode for measuring an electric potential of the catalytic reaction surface R is inserted into the oxidation bath 12A in a state extending upward through the bottom thereof.
A light transmitting window 12D for irradiating the catalytic reaction surface R with light L from a light source (not illustrated) through the electrolyte is formed in a portion opposing to the opening 15 in the peripheral wall of this oxidation bath 12A.
In FIG. 2, reference character 19a indicates a power source for application of voltage used in the case where a voltage is applied between the photocatalytic semiconductor device 10 and the metal electrode 18.

No particular limitation is imposed on the light source for irradiating the catalytic reaction surface R with light L so far as it emits light having energy higher than a band gap of the III/V group compound making up the III/V group nitride semiconductor 20, and the sun, mercury lamp, xenon lamp, incandescent lamp, fluorescent lamp, LED, laser or the like may be used.
When the III/V group compound making up the III/V group nitride semiconductor 20 is, for example, gallium nitride (GaN), the band gap is 3.4 eV, so that it is only necessary to emit light of 365 nm or less.

In such a photocatalytic oxidation-reduction reaction apparatus 11, a photoelectrochemical reaction is executed in the following manner. More specifically, when the electrolyte is, for example, water (H₂O), the catalytic reaction surface R of the photocatalytic semiconductor device 10 is first irradiated with light L from the light source through the light transmitting window 12D, whereby an electron (e⁻) and a hole (h⁺) are generated in the photocatalytic function layer portion 20A, an oxidation reaction that a hydroxide ion (OH⁻) or water (H₂O) in the electrolyte is oxidized is caused by the hole (h⁺) in a region of this catalytic reaction surface R, with which the electrolyte has come into contact, and a reduction reaction that a hydrogen ion (H⁺) or water (H₂O) in the electrolyte is reduced is caused by the electron (e⁻) transferred from the photocatalytic function layer portion 20A through the potentiostat 19 in a region of the surface of the metal electrode 18, with which the electrolyte has come into contact.
As a result, oxygen gas and hydrogen gas are generated in the photocatalytic semiconductor device 10 in the oxidation bath 12A and the metal electrode 18 of the reduction bath 12B, respectively, and these oxygen gas and hydrogen gas are collected in the respective gas collecting tubes 12E and 12F, respectively.

According to such a photocatalytic oxidation-reduction reaction apparatus 11, the photocatalytic function layer portion 20A to be irradiated with light has the full width at half maximum of the X-ray rocking curve of the specific size and the specific carrier density, so that the oxidation-reduction reaction can be caused at a high photoconversion efficiency by the irradiation of light on the catalytic reaction surface R.

In the above-described photocatalytic oxidation-reduction reaction apparatus 11, various changes may be added.
For example, the pair of electrodes for electrolysis is not limited to the use of the photocatalytic semiconductor device 10 having the n-type III/V group nitride semiconductor 20 and the metal electrode 18, and a photocatalytic semiconductor device (hereinafter also referred to as "p-type photocatalytic semiconductor device") having a p-type III/V group nitride semiconductor and the metal electrode may also be used. In this case, the p-type photocatalytic semiconductor device functions as a cathode, and the metal electrode functions as an anode. Specifically, the catalytic reaction surface of the p-type photocatalytic semiconductor device is irradiated with light, whereby an electron (e⁻) and a hole (h⁺) are generated in the photocatalytic function layer portion thereof, a reduction reaction that a hydrogen ion or water in an electrolyte is reduced is caused by the electron (e⁻) in the catalytic reaction surface, and an oxidation reaction that a hydroxide ion or water in the electrolyte is oxidized is caused by the hole (h⁺) transferred through the potentiostat 19 in the surface of the metal electrode.

For example, a photocatalytic semiconductor device (hereinafter also referred to as "n-type photocatalytic semiconductor device") having an n-type III/V group nitride semiconductor and the p-type photocatalytic semiconductor device may also be used as the pair of electrodes for electrolysis. In this case, the n-type photocatalytic semiconductor device functions as an anode to cause an oxidation reaction, and the p-type photocatalytic semiconductor device functions as a cathode to cause a reduction reaction.

### EXAMPLES

### [Production Example 1 of Photocatalytic Semiconductor Device]

A photocatalytic semiconductor device was produced in accordance with FIG. 1. More specifically, a substrate composed of sapphire was first annealed for 10 minutes at 1,100°C in hydrogen gas under 100 kPa, the temperature of the substrate was then lowered to 520°C, and trimethylgallium (TMGa) and ammonia (NH₃) were continuously fed to a (0001)+c plane of this substrate by using hydrogen gas as a carrier gas in such a manner that a proportion (V/III ratio) of a V group atom to a III group atom is about 5,000 to grow a buffer layer composed of gallium nitride (GaN) and having a thickness of 50 nm.
The temperature of the substrate was then raised to 1,040°C, trimethylgallium (TMGa) and ammonia (NH₃) were continuously fed to the surface of the buffer layer by using hydrogen gas as a carrier gas in such a manner that the V/III ratio is about 3,800, and 10 ppm of silane (SiH₄) diluted with hydrogen was continuously fed at a flow rate of 2 sccm to grow a III/V group nitride semiconductor doped with a silicon atom (Si), composed of gallium nitride (GaN) and having a thickness of 1.8 µm for 60 minutes, thereby obtaining an n-type photocatalytic semiconductor device [1].
With respect to this photocatalytic semiconductor device [1], the carrier density of the III/V group nitride semiconductor was measured in accordance with the van der Pauw's method and found to be 1.2 x 10¹⁷ cm⁻³, and the full width at half maximum of an X-ray rocking curve of a (0002) plane was measured and found to be 290 arcsec. The surface of this photocatalytic semiconductor device [1] was specular.

### [Production Example 1 of Referential Photocatalytic Semiconductor Device]

A referential n-type photocatalytic semiconductor device [2] was obtained in the same manner as in Production Example 1 of Photocatalytic Semiconductor Device except that the silane (SiH₄) diluted with hydrogen was fed at a flow rate of 10 sccm to grow a III/V group nitride semiconductor doped with a silicon atom (Si), composed of gallium nitride (GaN) and having a thickness of 3.8 µm for 120 minutes.
With respect to this referential photocatalytic semiconductor device [2], the carrier density of the III/V group nitride semiconductor was measured in accordance with the van der Pauw's method and found to be 4.0 x 10¹⁸ cm⁻³, and the full width at half maximum of an X-ray rocking curve of a (0002) plane was measured and found to be 320 arcsec. The surface of this referential photocatalytic semiconductor device [2] was specular.

### [Production Example 2 of Photocatalytic Semiconductor Device]

An n-type photocatalytic semiconductor device [3] was obtained in the same manner as in Production Example 2 of Photocatalytic Semiconductor Device except that the silane (SiH₄) diluted with hydrogen was fed at a flow rate of 5 sccm to grow a III/V group nitride semiconductor doped with a silicon atom (Si), composed of gallium nitride (GaN) and having a thickness of 3.9 µm.
With respect to this photocatalytic semiconductor device [3], the carrier density of the III/V group nitride semiconductor was measured in accordance with the van der Pauw's method and found to be 1.6 x 10¹⁸ cm⁻³, and the full width at half maximum of an X-ray rocking curve of a (0002) plane was measured and found to be 230 arcsec. The surface of this photocatalytic semiconductor device [3] was specular.

### [Production Example 1 of Comparative Photocatalytic Semiconductor Device]

A comparative n-type photocatalytic semiconductor device [a] was obtained in the same manner as in Production Example 2 of Photocatalytic Semiconductor Device except that the silane (SiH₄) diluted with hydrogen was fed at a flow rate of 20 sccm to grow a III/V group nitride semiconductor doped with a silicon atom (Si), composed of gallium nitride (GaN) and having a thickness of 3.8 µm.
With respect to this comparative photocatalytic semiconductor device [a], the carrier density of the III/V group nitride semiconductor was measured in accordance with the van der Pauw's method and found to be 7.4 x 10¹⁸ cm⁻³, and the full width at half maximum of an X-ray rocking curve of a (0002) plane was measured and found to be 340 arcsec. The surface of this comparative photocatalytic semiconductor device [a] had irregularities in which truncated hexahedral projections were formed.

### [Production Example 2 of Comparative Photocatalytic Semiconductor Device]

A comparative n-type photocatalytic semiconductor device [b] was obtained in the same manner as in Production Example 1 of Photocatalytic Semiconductor Device except that the silane (SiH₄) diluted with hydrogen was fed at a flow rate of 5 sccm to grow a III/V group nitride semiconductor doped with a silicon atom (Si), composed of gallium nitride (GaN) and having a thickness of 1.5 µm for 60 minutes.
With respect to this comparative photocatalytic semiconductor device [b], the carrier density of the III/V group nitride semiconductor was measured in accordance with the van der Pauw's method and found to be 9.3 x 10¹⁷ cm⁻³, and the full width at half maximum of an X-ray rocking curve of a (0002) plane was measured and found to be 860 arcsec. The surface of this comparative photocatalytic semiconductor device [b] was specular.

### [Production Example 3 of Comparative Photocatalytic Semiconductor Device]

A comparative n-type photocatalytic semiconductor device [c] was obtained in the same manner as in Production Example 1 of Photocatalytic Semiconductor Device except that a III/V group nitride semiconductor doped with no silicon atom (Si), composed of gallium nitride (GaN) and having a thickness of 3.4 µm was grown for 45 minutes without feeding the silane (SiH₄) diluted with hydrogen.
With respect to this comparative photocatalytic semiconductor device [c], the carrier density of the III/V group nitride semiconductor was measured in accordance with the van der Pauw's method and found to be 4.0 x 10¹⁶ cm⁻³, and the full width at half maximum of an X-ray rocking curve of a (0002) plane was measured and found to be 630 arcsec. The surface of this comparative photocatalytic semiconductor device [c] was specular.

### [Production Example 4A of Photocatalytic Semiconductor Device]

An n-type photocatalytic semiconductor device [4A] was obtained in the same manner as in Production Example 1 of Photocatalytic Semiconductor Device except that the growth was conducted for 60 minutes in a state that the silane (SiH₄) diluted with hydrogen was not fed to grow a III/V group nitride semiconductor doped with a silicon atom (Si) and composed of gallium nitride (GaN). The thickness thereof is shown in Table 1.

### [Production Examples 4B, 4C and 4E to 4G of Photocatalytic Semiconductor Device]

n-type Photocatalytic semiconductor devices [4B], [4C] and [4E] to [4G] were obtained in the same manner as in Production Example 1 of Photocatalytic Semiconductor Device except that the growth was conducted for 60 minutes in a state that the silane (SiH₄) diluted with hydrogen was fed at flow rates of 1 sccm, 2 sccm, 3 sccm, 5 sccm and 10 sccm, respectively, to grow III/V group nitride semiconductors doped with a silicon atom (Si) and composed of gallium nitride (GaN). The thicknesses thereof are shown in Table 1.

### [Production Example 4D of Photocatalytic Semiconductor Device]

An n-type photocatalytic semiconductor device [4D] was obtained in the same manner as in Production Example 1 of Photocatalytic Semiconductor Device except that the growth was conducted for 60 minutes in a state that the flow rate of trimethylgallium (TMGa) fed to the surface of the buffer layer was doubled, and the silane (SiH₄) diluted with hydrogen was fed at a flow rate of 3 sccm to grow a III/V group nitride semiconductor doped with a silicon atom (Si) and composed of gallium nitride (GaN). The thickness thereof is shown in Table 1.

With respect to the photocatalytic semiconductor devices [4A] to [4G] obtained above, the carrier densities of the III/V group nitride semiconductors as measured in accordance with the van der Pauw's method, and the full widths at half maximum of X-ray rocking curves of respective (0002) planes are shown in Table 1. All the surfaces of the photocatalytic semiconductor devices [4A] to [4G] were specular.

### [Production Examples 5A and 5C of Photocatalytic Semiconductor Device]

n-type Photocatalytic semiconductor devices [5A] and [5C] were obtained in the same manner as in Production Example 1 of Photocatalytic Semiconductor Device except that the growth was conducted for 120 minutes and 60 minutes, respectively, in a state that the growth conditions were changed, and the silane (SiH₄) diluted with hydrogen was fed at flow rates of 5 sccm and 2 sccm, respectively, to grow III/V group nitride semiconductors doped with a silicon atom (Si) and composed of gallium nitride (GaN). The thicknesses thereof are shown in Table 1.

### [Production Examples 5B, 5D and 5F of Photocatalytic Semiconductor Device]

n-type Photocatalytic semiconductor devices [5B], [5D] and [5F] were obtained in the same manner as in Production Example 1 of Photocatalytic Semiconductor Device except that the growth was conducted for 60 minutes in a state that the silane (SiH₄) diluted with hydrogen was fed at flow rates of 3 sccm, 5 sccm and 10 sccm, respectively, to grow III/V group nitride semiconductors doped with a silicon atom (Si) and composed of gallium nitride (GaN). The thicknesses thereof are shown in Table 1.

### [Production Example 5E of Photocatalytic Semiconductor Device]

An n-type photocatalytic semiconductor device [5E] was obtained in the same manner as in Production Example 1 of Photocatalytic Semiconductor Device except that the growth was conducted for 60 minutes in a state that the flow rate of trimethylgallium (TMGa) fed to the surface of the buffer layer was doubled, and the silane (SiH₄) diluted with hydrogen was fed at a flow rate of 3 sccm to grow a III/V group nitride semiconductor doped with a silicon atom (Si) and composed of gallium nitride (GaN). The thickness thereof is shown in Table 1.

### [Production Example 5G of Referential Photocatalytic Semiconductor Device]

A refereutial n-type Photocatalytic semiconductor device [5G] was obtained in the same manner as in Production Example 1 of Photocatalytic Semiconductor Device except that the growth was conducted for 120 minutes in a state that the growth conditions were changed, and the silane (SiH₄) diluted with hydrogen was fed at a flow rate of 10 sccm to grow a III/V group nitride semiconductor doped with a silicon atom (Si) and composed of gallium nitride (GaN). The thickness thereof is shown in Table 1.

### [Production Example 5h of Comparative Photocatalytic Semiconductor Device]

A comparative n-type photocatalytic semiconductor device [5h] was obtained in the same manner as in Production Example 1 of Photocatalytic Semiconductor Device except that the growth was conducted for 60 minutes in a state that the silane (SiH₄) diluted with hydrogen was fed at a flow rate of 20 sccm to grow a III/V group nitride semiconductor doped with a silicon atom (Si) and composed of gallium nitride (GaN). The thickness thereof is shown in Table 1.

### [Production Example 5i of Comparative Photocatalytic Semiconductor Device]

A comparative n-type Photocatalytic semiconductor device [5i] was obtained in the same manner as in Production Example 1 of Photocatalytic Semiconductor Device except that the growth was conducted for 60 minutes in a state that the growth conditions were changed, and the silane (SiH₄) diluted with hydrogen was fed at a flow rate of 5 sccm to grow a III/V group nitride semiconductor doped with a silicon atom (Si) and composed of gallium nitride (GaN). The thickness thereof is shown in Table 1.

With respect to the photocatalytic semiconductor devices [5A] to [5F], referential photocatalytic semiconductor device [5G], and comparative photocatalytic semiconductor devices [5h] and [5i] obtained above, the carrier densities of the III/V group nitride semiconductors as measured in accordance with the van der Pauw's method, and the full widths at half maximum of X-ray rocking curves of respective (0002) planes are shown in Table 1. All the surfaces of the photocatalytic semiconductor devices [5A] to [5F], referential photocatalytic semiconductor device [5G], and comparative photocatalytic semiconductor devices [5h] and [5i] were specular.

**[Table 1]**

| Photocatalytic Semiconductor Device | Thickness (µm) | Carrier Density (cm⁻³) | Full Width at Half Maximum (arcsec) |
|---|---|---|---|
| 4 A | 3.3 | 2.1×10¹⁶ | 220 |
| 4 B | 2.9 | 5.5×10¹⁶ | 270 |
| 4 C | 2.8 | 1.2×10¹⁷ | 250 |
| 4 D | 6.2 | 1.7×10¹⁷ | 290 |
| 4 E | 3.1 | 3.1×10¹⁷ | 230 |
| 4 F | 2.9 | 1.0×10¹⁸ | 290 |
| 4 G | 3.2 | 2.6×10¹⁸ | 290 |
| 5 A | 3.9 | 1.6×10¹⁸ | 230 |
| 5 B | 3.1 | 3.1×10¹⁷ | 230 |
| 5 C | 1.8 | 1.2×10¹⁷ | 290 |
| 5 D | 2.9 | 1.0×10¹⁸ | 290 |
| 5 E | 6.2 | 1.7×10¹⁷ | 290 |
| 5 F | 3.2 | 2.6×10¹⁸ | 290 |
| 5 G | 3.8 | 4.0×10¹⁸ | 320 |
| 5 h | 3.1 | 5.9×10¹⁸ | 450 |
| 5 i | 1.5 | 9.3×10¹⁷ | 860 |

### Photocatalytic oxidation-reduction reaction apparatus were produced in accordance with FIG. 2.

Specifically, each of the photocatalytic semiconductor devices [1] and [3], referential photocatalytic semiconductor device [2], comparative photocatalytic semiconductor devices [a] to [c], photocatalytic semiconductor devices [4A] to [4G], photocatalytic semiconductor devices [5A] to [5F], referential photocatalytic semiconductor device [5G], and comparative photocatalytic semiconductor devices [5h] and [5i] was used as an anode, and a collecting member obtained by laminating titanium and gold was provided at an outer peripheral portion of the surface forming the catalytic reaction surface thereof and electrically connected to a cathode by a conductive wire. A platinum electrode was used as the cathode, a silver/silver chloride/sodium chloride electrode was used as a reference electrode, and 1 mol/L HCl was used as an electrolyte, thereby producing photocatalytic oxidation-reduction reaction apparatus [1] and [3], a referential photocatalytic oxidation-reduction reaction apparatus [2], comparative photocatalytic oxidation-reduction reaction apparatus [a] to [c], photocatalytic oxidation-reduction reaction apparatus [4A] to [4G], photocatalytic oxidation-reduction reaction apparatus [5A] to [5F], a referential photocatalytic oxidation-reduction reaction apparatus [5G], and comparative photocatalytic oxidation-reduction reaction apparatus [5h] and [5i].
Each apparatus was so constructed that a circular region having a diameter of 10 mm at a central portion of the surface forming the catalytic reaction surface was irradiated with light from a light source composed of a xenon lamp of 150 W.

### <Examples 1 and 2, Referential Example 1, and Comparative Examples 1 to 3]

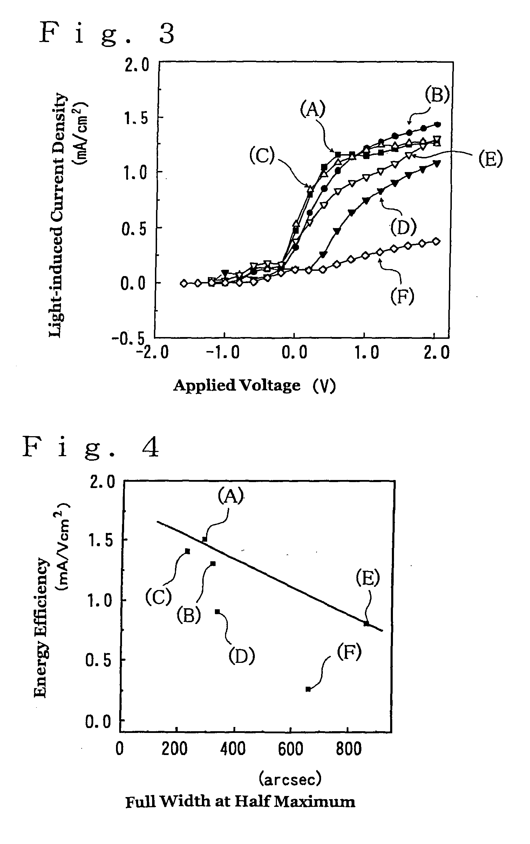

Each of the photocatalytic oxidation-reduction reaction apparatus [1] and [3], referential photocatalytic oxidation-reduction reaction apparatus [2], and comparative photocatalytic oxidation-reduction reaction apparatus [a] to [c] was used to measure a light-induced current density (mA/cm²) to an applied voltage (V). The results are illustrated in FIG. 3. In the graph illustrated in FIG. 3, a slope (hereinafter also referred to as "energy efficiency") of an increment of the applied voltage to an increment of the light-induced current density at a position where the light-induced current density rapidly rose was calculated out to investigate the relationship between the energy efficiency and the full width at half maximum of an X-ray rocking curve. The results are illustrated in FIG. 4.
In FIG. 3 and FIG. 4, the results relating to the photocatalytic oxidation-reduction reaction apparatus [1], referential photocatalytic oxidation-reduction reaction apparatus [2], photocatalytic oxidation-reduction reaction apparatus [3], and comparative photocatalytic oxidation-reduction reaction apparatus [a] to [c] are indicated by (A), (B), (C), and (D) to (F), respectively.

As apparent from the results in FIG. 3 and FIG. 4, it was confirmed that in the photocatalytic oxidation-reduction reaction apparatus [1] and [3] according to Examples 1 and 2, the energy efficiency is high, and a high light-induced current density is obtained even in the vicinity of zero bias. In fact, in order to surely cause an oxidation-reduction reaction at zero bias, a light-induced current density of about 0.3 mA/cm², preferably about 0.4 mA/cm², more preferably about 0.5 mA/cm² is required. In order to achieve this light-induced current density at zero bias, it is necessary for the energy efficiency to exceed 1 mA/Vcm². In this regard, detailed experiments were conducted in the following Examples 4A to 4G, and Examples 5A to 5G and Comparative Examples 5h and 5i.
On the other hand, Comparative Example 1 where the carrier density was too high was observed causing irregularities at the catalytic reaction surface and confirmed that the energy efficiency was reduced compared with Example 2 where the full width at half maximum of the X-ray rocking curve was comparable. Comparative Example 2 where the full width at half maximum of the X-ray rocking curve was too great was confirmed that the energy efficiency was low. In Comparative Example 3 where the carrier density was too low, only an extremely low light-induced current density was obtained even when application of voltage was conducted together with the irradiation of light.

### <Examples 4A to 4G>

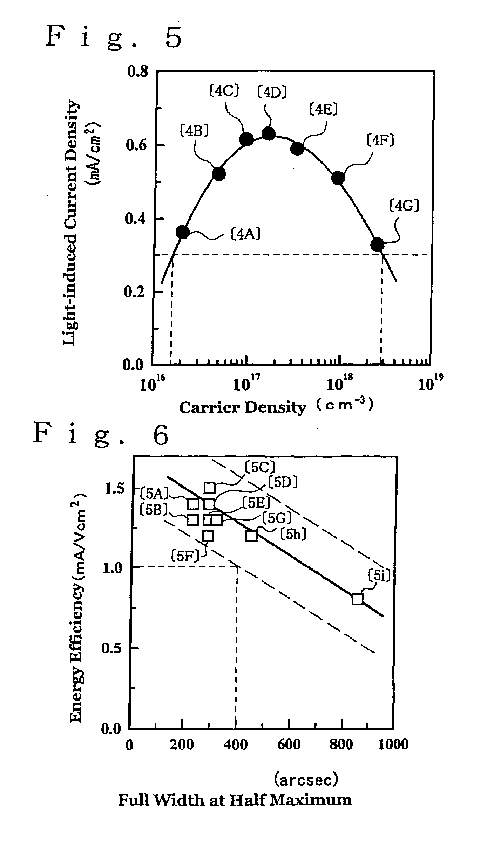

Each of the photocatalytic oxidation-reduction reaction apparatus [4A] to [4G] was used to measure a light-induced current density (mA/cm²) at zero bias. The results are illustrated in FIG. 5 as the relationship between the carrier density and the light-induced current density. In FIG. 5, the results relating to the photocatalytic oxidation-reduction reaction apparatus [4A] to [4G] are indicated by [4A] to [4G], respectively.

As apparent from the results in FIG. 5, it was confirmed that a light-induced current density of 0.3 mA/cm² or higher was obtained in a carrier density range of from 2.1 x 10¹⁶ cm⁻³ to 2.6 x 10¹⁸ cm⁻³ in the photocatalytic oxidation-reduction reaction apparatus [4A] to [4G] depending on the III/V group nitride semiconductors whose full width at half maximum of the X-ray rocking curve was 300 arcsec or less.

### <Examples 5A to 5F, Referential Example 5G, and Comparative Examples 5h and 5i>

Each of the photocatalytic oxidation-reduction reaction apparatus [5A] to [5F], referential photocatalytic oxidation-reduction reaction apparatus [5G], and comparative photocatalytic oxidation-reduction reaction apparatus [5h] and [5i] was used to measure a light-induced current density (mA/cm²) to an applied voltage (V), and an energy efficiency in each measured result was calculated out to investigate the relationship between the energy efficiency and the full width at half maximum of the X-ray rocking curve. The results are illustrated in FIG. 6. In FIG. 6, the results relating to the photocatalytic oxidation-reduction reaction apparatus [5A] to [5F], referential photocatalytic oxidation-reduction reaction apparatus [5G], and comparative photocatalytic oxidation-reduction reaction apparatus [5h] and [5i] are indicated by [5A] to [5F], [5G], and [5h] and [5i], respectively.

As apparent from the results in FIG. 6, it was confirmed that an energy efficiency exceeding 1 mA/Vcm² was achieved in the photocatalytic oxidation-reduction reaction apparatus [5A] to [5F] and referential photocatalytic oxidation-reduction reaction apparatus [5G] depending on the III/V group nitride semiconductors whose full width at half maximum of the X-ray rocking curve was 320 arcsec or less.

In FIG. 4 and FIG. 6, straight lines are approximate straight lines of plots (A) to (F) indicating the relationship between the energy efficiency and the full width at half maximum of the X-ray rocking curve in Examples 1 and 2, Referential Example 1, and Comparative Examples 1 to 3, and plots [5A] to [5G], [5h] and [5i] indicating the relationship between the energy efficiency and the full width at half maximum of the X-ray rocking curve in Examples 5A to 5G, and Comparative Examples 5h and 5i. It is inferred that an energy efficiency can be presumed from the full width at half maximum of the X-ray rocking curve of a III/V group nitride semiconductor having a carrier density within a certain range by using this line.

## Claims

1. A III/V group nitride semiconductor for photocatalytic oxidation-reduction reaction, wherein
the full width at half maximum of an X-ray rocking curve on a catalytic reaction surface of the III/V group nitride semiconductor is 400 arcsec or less, and
a carrier density in a surface layer portion having the catalytic reaction surface is 1.5 x 10¹⁶ cm⁻³ or more, but 3. 0 x 10¹⁸ cm⁻³ or less.

2. The III/V group nitride semiconductor according to claim 1, wherein the resistivity of the surface layer portion is 7 x 10⁻³ Ωcm or more, but 6 x 10⁻¹ Ωcm or less.

3. A photocatalytic semiconductor device for photocatalytic oxidation-reduction reaction, wherein
the III/V group nitride semiconductor according to claim 1 or 2 is laminated on a substrate.

4. A photocatalytic oxidation-reduction reaction apparatus for photocatalytic oxidation-reduction reaction, wherein
one electrode of a pair of electrodes for electrolysis, which are electrically connected to each other in a state brought into contact with an electrolyte, is composed of the III/V group nitride semiconductor according to claim 1 or 2, and
a catalytic reaction surface making up the III/V group nitride semiconductor is irradiated with light, thereby causing an oxidation reaction or reduction reaction on the catalytic reaction surface.

5. The photocatalytic oxidation-reaction reaction apparatus according to claim 4, wherein the catalytic reaction surface in the III/V group nitride semiconductor is irradiated with light, and a voltage is applied between the pair of electrodes for electrolysis, thereby causing the oxidation reaction or reduction reaction on the catalytic reaction surface.

6. An execution process of a photoelectrochemical reaction comprising using the III/V group nitride semiconductor according to claim 1 or 2 and irradiating the catalytic reaction surface in the III/V group nitride semiconductor with exciting light to cause an oxidation reaction or reduction reaction on the catalytic reaction surface.
